Europäisches Patentamt

European Patent Office

Office européen des brevets

(11) Publication number: **0 046 648**
**B1**

(12) **EUROPEAN PATENT SPECIFICATION**

(45) Date of publication of patent specification: **31.10.84**

(51) Int. Cl.³: **H 01 L 39/22**

(21) Application number: **81303710.8**

(22) Date of filing: **14.08.81**

(54) Method of making Josephson junction devices.

(30) Priority: **18.08.80 US 179311**

(43) Date of publication of application:
**03.03.82 Bulletin 82/09**

(45) Publication of the grant of the patent:
**31.10.84 Bulletin 84/44**

(84) Designated Contracting States:
**CH DE FR GB IT LI**

(56) References cited:

IBM TECHNICAL DICLOSURE BULLETIN, vol.
18, no. 7, December 1975, NEW YORK (US), W.
WALTER: "Manufacturing Josephson junctions
on a single step", page 2328
IEEE TRANSACTIONS ON MAGNETICS, vol.
MAG-15, no. 1, January 1979, NEW YORK (US),
H. KROGER et al.: "Niobium Josephson
junctions with doped amorphous silicon
barriers", pages 488-489

(73) Proprietor: **SPERRY CORPORATION**
**1290, Avenue of the Americas**
**New York, N.Y. 10019 (US)**

(72) Inventor: **Kroger, Harry**
**67 Wake Robin Road**
**Sudbury Massachusetts 01776 (US)**

(74) Representative: **Orchard, Oliver John**
**JOHN ORCHARD & CO. Staple Inn Buildings**
**North High Holborn**
**London WC1V 7PZ (GB)**

Courier Press, Leamington Spa, England.

## Description

The invention relates to a method of making Josephson junction devices.

Superconductive memory and logic circuits are well known in the art which utilise the Josephson junction as an active switching or gating element. The Josephson junction device may also be employed as a magnetic field sensor, as in magnetometers and in electromagnetic wave detectors. The Josephson junction device normally comprises two adjacent layers of superconductive material with a barrier layer between them; current flows from one superconductive layer to the other through the barrier by tunnel effect. With the superconductive layers connected into a superconductive loop and with control lines disposed adjacent the junction, the Josephson zero-voltage direct current flowing through the device is controlled so as to provide the current steering and control functions in associated circuits.

A particular Josephson junction device, as well as problems arising with prior art devices, are described in European patent application number 79300758.4 (publication number 0005364), corresponding to U.S. patent 4 176 365.

As discussed in the above European patent application, it is desirable to provide Josephson junction devices capable of supporting large critical current densities while still utilising relatively thick barrier layers so as to provide structural rigidity and reliability and to decrease device capacitance. Oxide insulator tunnelling barrier layers have generally been unsatisfactory in the past, in that only relatively thin and consequently fragile insulator barriers could pass large Josephson direct currents, the thin barriers resulting in Josephson devices with undesirably high capacitance. The device of the above patent application utilises appropriately doped amorphous hydrogenated silicon, germanium, or alloys thereof as the barrier layer material, which permits an unusually high current density through a suitably thick tunnelling barrier layer.

Also providing readily reproducible high current density, small Josephson superconducting loops utilising small area tunnel junctions and having barriers of sufficient thickness are the devices of the European patent application 80300841.6 (publication number 0017389) claiming priority from U.S. patent application number 23 487 filed March 23, 1979. As discussed also in the former of the patent applications mentioned above, it is desirable to utilize refractory superconductive metals in fabricating Josephson junction devices. Generally, non-refractory materials have been used in prior art devices. Although non-refractory superconductive metals such as lead, indium, and tin, and alloys thereof, exhibit suitable superconductive properties, these materials cause difficulties when fabricating superconducting integrated circuits using fine line connections. Printed circuit fabrication techniques that tend partially to ameliorate these difficulties tend to be more complicated than more conventional fabrication techniques that presently produce high yield integrated circuits of a more conventional variety, such as in ordinary semiconductor circuits. In place of the soft, relatively low melting point superconductive metals mentioned, aluminium has been utilised as the superconductor to alleviate the problem, but aluminium has a significantly lower superconductive transition temperature than, for example, lead and therefore it requires much more energy to refrigerate the devices.

The latter of the above applications additionally concerns an improvement like that of the former application that overcomes additional disadvantages of the prior art. In that application a Josephson junction device is provided with two layers of superconductive material, the lower one being of a refractory compound superconductive metal, and with a barrier layer between them of polycrystalline silicon, germanium, or an alloy thereof. Preferably, the lower superconductive layer is of niobium nitride and the barrier layer is deposited on it by chemical vapour deposition.

The present invention is a method of fabricating improved Josephson devices in which the active area is defined by a local anodisation or oxidation process after both superconducting layers have been formed, a sequence of events important in that it permits impurities at the sealed tunnelling barrier layer interfaces to be minimised. In addition to producing inherently cleaner interfacial regions, the method permits easy and convenient fabrication of geometric variations of known Josephson devices.

In the article "Manufacturing Josephson junctions in a single step", by W. Walter in IBM Technical Disclosure Bulletin Volume 18, Page 2328 (December 1975), there is a proposal for a method of manufacturing Josephson junctions. In this proposed method a metal base electrode layer, preferably of niobium, is deposited on a substrate, followed by a tunnel layer, and a thin metal layer which forms at least part of the counterelectrode. To obtain the shape of the bottom electrode a mask is applied, and all metal of the protective layer and the bottom electrode outside the mask is oxidized, preferably, in the case of niobium, by electrolytic oxidation in a bath. The article then proposes further masking and oxidation steps.

This proposal as described is unworkable. It would leave a three-layer sandwich corresponding in outline to the mask, with no means of making any electrical connection to the bottom layer, which is to function as the base electrode. Furthermore, it is impossible to remove the metal layers by electrolytic oxidation as suggested in the article, since as soon as any small area of the layer is fully oxidized, it pinches off the current supply to the regions lying beyond, with the result that, when the area around the contact has become oxidized, current flow ceases, leaving isolated areas of metal unconnected with each other or with the electrical contact.

In the present invention, as defined in the claims which follow, a simple modification of this process overcomes these difficulties. All that is necessary is to limit the oxidation step so that, while the whole of the top counterelectrode layer is oxidized, little or none of the base electrode layer is oxidized.

In the drawings:

Figures 1 and 4 are cross-sectional views of a device at different stages of manufacture by the method of the invention.

Figure 5 is a similar view illustrating a modification of the method.

Figure 6 is a top view of the structure of Figure 4.

Figure 7, 8, and 9 are cross-sectional views of one device manufactured by the method of the invention, showing successive steps in its construction.

Figure 10 is a cross-sectional view of a further device manufactured by the method of the invention.

Figures 11 and 12 are cross-sectional views taken across the respective lines 11—11 and 12—12 of Figure 10.

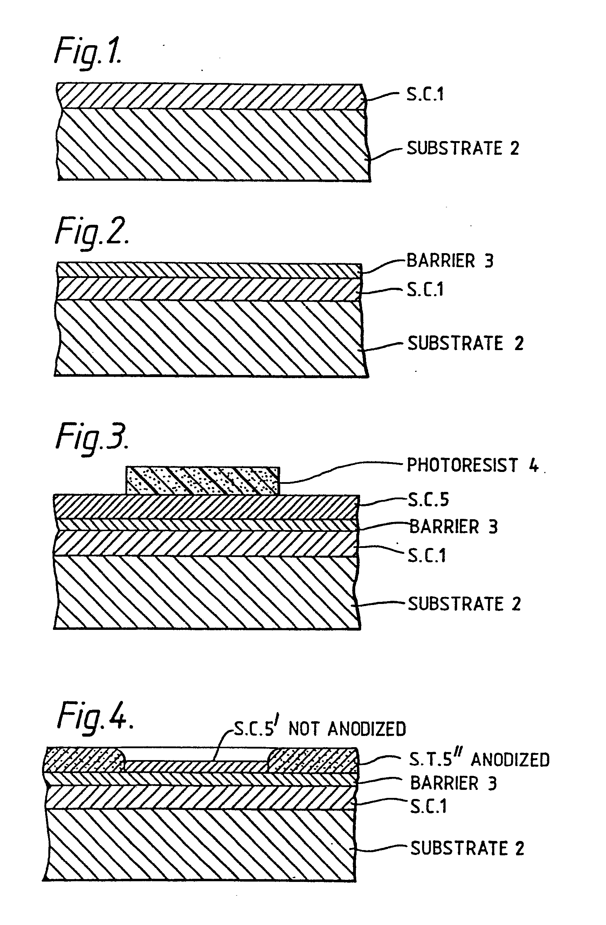

Figure 1 shows the first step in the manufacture of a Josephson device by the method of the invention. A superconducting layer 1 is formed on a substrate 2 by known methods and acts as a transmission line. The substrate 2 may consist of detailed elements (not shown) including an external layer of oxidised silicon, an intermediate layer of a refractory superconductor material, such as niobium, and an insulating layer which will ultimately interface with the superconducting transmission line 1, in the usual manner. Reference may be made to the two above-mentioned European patent applications.

The substrate 2 may include a base or external layer of a crystalline silicon substrate with an oxidised surface; next a layer 1000 to 5000 Angstroms (100 to 500 nm) thick of niobium is deposited on the oxide surface in a conventional way by sputtering to serve as a transmission line ground plane. A silicon dioxide or amorphous silicon dielectric layer is finally formed on the free surface of the dielectric layer to a depth of 1000 to 20,000 Angstroms (100—2000 nm). In this manner, which is conventional, the substrate 2 of the device is formed, and this may then be prepared to accept a particular Josephson device configuration on its dielectric surface, as in Figure 1, where a first superconductor layer 1 is shown on the substrate, patterning of layer 1 being generally not necessary according to the invention. The layer 1 may be niobium, sputter- deposited in the usual manner to a depth of about 2000 to 3000 Angstroms (200 to 300 nm).

In the same vacuum chamber and without interruption, the succeeding step of r.f. diode sputter deposition of a 30 to 400 Angstrom thick tunnelling barrier layer 3 (Figure 2) is performed in a partial hydrogen atmosphere. The barrier layer 3 may consist, for example, of amorphous hydrogenated silicon or of amorphous hydrogenated germanium or of alloys thereof, and the barrier layer material may be doped with a type n or p dopant during the deposition step, for example by the addition of phosphene to the sputtering atmosphere. For relative thin semiconductor barrier layers 3, there may be a need for a surface oxidation step to plug any pin holes in the semiconductor material, though this is normally an optional step. Advantageously, no patterning of the barrier layer 3 needs to be undertaken according to this method.

As described in the first mentioned European patent application, an unexpectedly large increase in Josephson current density is obtained by use of the amorphous hydrogenated silicon, amorphous hydrogenated germanium, or amorphous hydrogenated silicon-germanium alloy as a tunnelling barrier in Josephson junction devices. For example, it was found that a prior art amorphous unhydrogenated silicon barrier about 30 Angstroms (3 nm) thick passed a maximum Josephson current of 120 amperes per square centimeter. On the other hand, a hydrogenated phosphorus-doped amorphous silicon barrier about 60 Angstroms (6 nm) thick supported a Josephson current density of 2000 to 4000 amperes per square centimeter.

A further step is now performed, preferably within the same vacuum chamber, to form the second of the two superconducting layer, 5, on the barrer 3, either by electron beam evaporation or by sputter deposition at a $20 \mu$ T pressure of argon of a layer 200 to 400 Angstroms (20 to 40 nm) thick, for instance, of a refractory superconductor such as niobium. The layer 5 will serve as the counterelectrode with respect to the semiconductor barrier 3, and is made thin, so that portions of it may be completely anodised or oxidised.

Referring now to Figure 3, a conventional photoresist layer 4 is next applied to the free surface of the superconductor layer 5. Application of the resist and its exposure and development are carried out in the usual manner so that a protective photoresist pattern 4 is left on the superconductor 5 surface only over the region 5' where an isolated active Josephson barrier is to be formed.

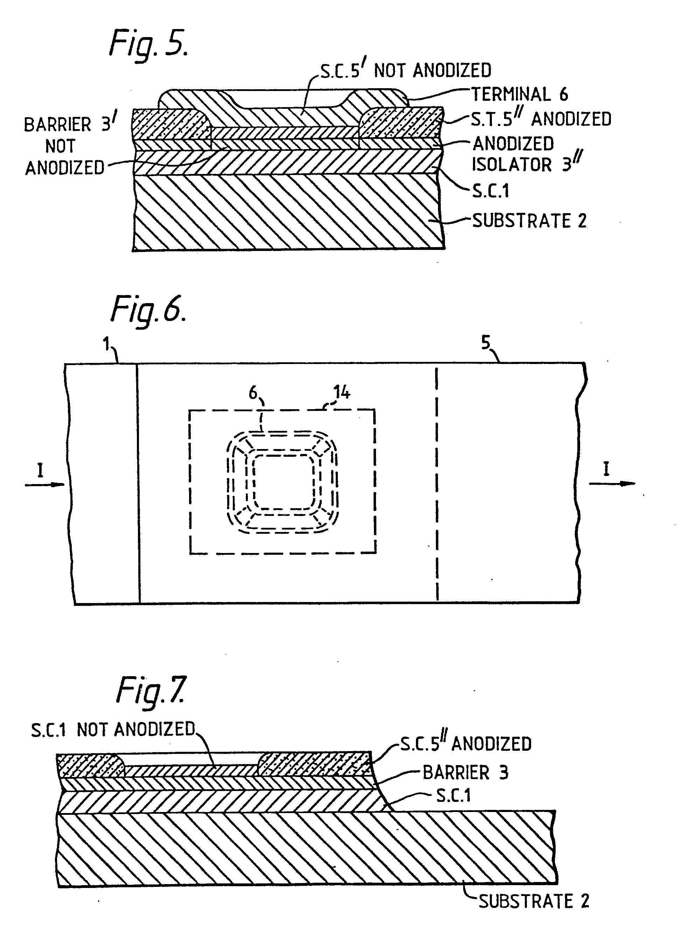

The active barrier area may be square, as suggested in Figure 6 or rectangular, circular, oval, et cetera. The active barrier region, as made according to the present invention, is enclosed by the superconducting layers, so that subsequent chemical or other treatment of the wafer can have no adverse effects upon the purity of the barrier itself.

In the next step, oxidation of the portion 5″ of the superconducting layer 5 is carried out as in Figure 4, to the active Josephson junction to the interface between the layers 5 and 3. The exposed part of the layer 5 grows somewhat thicker during the anodising or oxidising process; for example, anodising about 7 Angstroms (0.7 nm) of niobium produces a layer of niobium oxide about 20 Angstroms (2 nm) thick. If silicon is used as the semiconductor of the barrier 3, this layer 3 may also be partly or fully anodised or oxidised in the region 3″ not shielded by the photoresist island 4, as shown in Figure 5. The superconductor layer 5 is protected as seen in Figure 4 except within the region 5 covered by the resist 4 and the photoresist island 4 is then removed in the conventional manner. The superconducting transmission line 5 is thus not anodised in the layer region 5′ that is simply cross-hatched in the drawing while it is anodised in the regions 5″ both cross-hatched and stippled. In niobium-amorphous silicon-niobium structures, for example, the present anodisation method is preferred because of the chemical reactions and interdiffusions which may take place between niobium and silicon at about 300°C in other methods.

Figure 5 shows the non-anodised barrier layer and superconductor regions 3′ and 5′ respectively surrounded by anodised insulating semiconductor material 3″ and superconductor material 5″ also anodised or oxidised to form an insulating portion. The anodised region is chosen to be so thick that tunnelling can not take place through it.

Electrolytic anodisation may be accomplished for forming electrically resistive layers with respect to the refractory and semiconductor materials according to well known practice using a solution of ammonium pentaborate and ethylene glycol in water where the material to be anodised serves as the anode, the cathode being a Pt electrode. About 7.5 Angstroms (0.75 nm) of the niobium layer are consumed and about 20 Angstroms (2 nm) of niobium oxide is produced for each volt-ampere applied to the anodisation cell. After the anodisation step, and removal of the photoresist island 4, the partial product, as shown in Figures 4 or 5, is ready for further processing to fit the particular needs of the structure in which it is to be employed.

To prepare the partial product for that purpose, selected, generally conventional, steps may be taken. Any desired external patterning of the periphery of the unanodised portions of barrier layer 3 and of the input superconductor line 1 remote from the active Josephson region may be performed with one photoresist application and plasma etching through both of the layers. An insulating silica layer may then be deposited and patterned, as needed, over undesired bare conductor edges produced in the foregoing step. Deposition and patterning of further control superconducting lines on the upper surface of the partial product may then be undertaken, as desired.

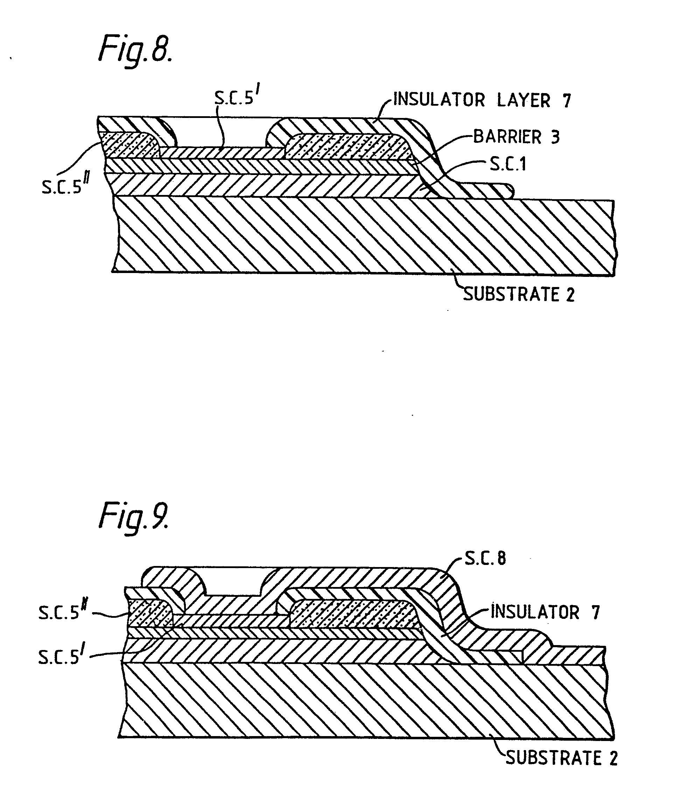

For example, reference may be had to Figures 7, 8, and 9, which illustrate construction steps that may be taken subsequent to those illustrated in Figures 4 or 5. Patterning of the anodised layer 5″ and of the lower superconductor transmission line 1 may be performed with a single photoresist application and plasma etching through both the anodised and unanodised layers simultaneously. The step may alter the structure of Figure 4 to remove layers 1, 3, and 5″ above substrate 2, as shown in Figure 7. As in Figure 8, an insulating layer 7 is then deposited and patterned over the layered structure, but over only a part of the exposed substrate 2. Insulator layer 7 serves primarily to cover conductor edges which must not remain exposed indefinitely. As in Figure 9, the superconducting transmission line 8 may then be deposited so that it makes contact with the superconductor layer 5′, extending over the layered structure and then over the surface of substrate 2.

In the second European patent application mentioned herein other refractory semiconductors are taught that may be employed in the present configuraton. In particular, the refractory superconductive compound niobium nitride does not react with hydrogen at temperatures up to 750°C in concentrations thereof required to deposit polycrystalline silicon, germanium, or alloys thereof. Furthermore, niobium nitride does not react with silicon or germanium or alloys thereof at the temperatures up to 750°C required for the chemical vapour deposition of these materials at atmospheric pressure. Thus, niobium nitride may be utilised as the superconductive material in the present Josephson junction devices where polycrystalline silicon, germanium, or alloys thereof are to be chemically vapour deposited. It is also believed that other compound refractory superconductors such as niobium-tin ($Nb_3Sn$) and niobium-germanium ($Nb_3Ge$) may be utilised to the same effect. The niobium nitride layers 10 and 11, for example, may be deposited by reactive sputtering of niobium in a partial nitrogen atmosphere onto a substrate heated to approximately 600°C or, alternatively, by chemical vapour deposition.

Returning to Figure 3, an alternative procedure is to avoid the use of the resist island 4 by depositing and patterning a different insulator layer, such as silica, so that it is left only over the region under which the Josephson device is to be placed. The silica island is again used to block anodisation of the active barrier layer 5. For small area junction devices, the use of a silica layer may provide more accurate control over the area of the active barrier region which is not to be anodised than does the photoresist island, since the resist may tend to lift off at higher anodisation voltages. When it is to be removed, the silica island may be subjected to a conventional buffered hydrofluoric acid solution adjusted so that the etch rate of the silica is 10 to 15 times that of the anodised niobium.

Alternative to anodisation, the insulating layer may be formed by thermal oxidation, depending upon the materials present. For a structure using NbN and Si, thermal oxidation is preferred because layers of NbN thicker than about 150 Angstroms (15 nm) are more difficult to anodise completely than to oxidise thermally, NbN and Si not reacting below 750°C. Following thermal oxidation, the $SiO_2$ layer may be removed in a conventional manner, as by using a buffered HF acid solution which will attack $SiO_2$ faster than the oxidised superconductor. If the differential etch rate is not high enough, photoresist masking may be used to prevent any chemical attack of the $SiO_2$. Deposition and patterning of the insulator layer and of the upper superconducting transmission lines may then proceed as in the foregoing.

The invention may also be practiced employing a barrier layer that is a native oxide of the lower superconductor. Instead of depositing a semiconductor barrier, the native oxide barrier is grown conventionally by thermal oxidation, plasma oxidation, chemical oxidation, or by some combination thereof before the counter superconductor electrode is deposited.

The methods of the invention offer the advantage that neither of the interfaces between the superconductor and the associated semiconductor barrier has to be exposed to any wet chemical process and the risk of contamination in the vacuum system is reduced. Since the latter is normally a high quality, high vacuum system, contamination during steps taking place in vacuum is actually not likely. The methods also ensure reliably reproducible products, eliminating uneven coverage of the lower superconductor by the barrier layer. Pairs and other multiplicities of Josephson junctions may readily be simultaneously produced. Also various shapes of the junction may be selected, further illustrating the versatility of the invention.

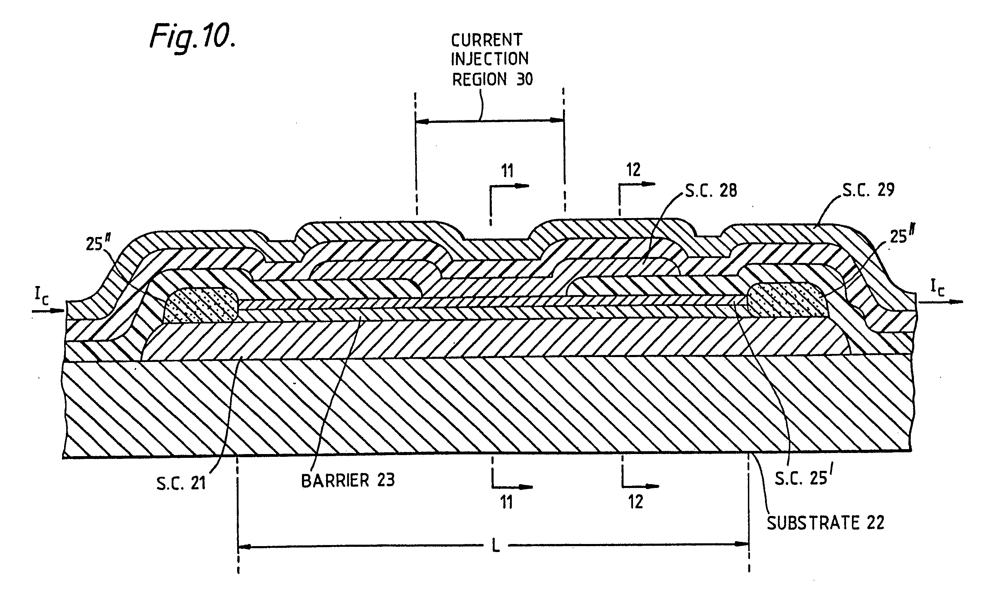

The versatility of the invention is represented in the foregoing embodiments in otherwise generally conventional Josephson tunnel junction devices and is further confirmed by considering its utility in the vortex type of Josephson junction as described by K. K. Likharev, V. K. Semenov, O. V. Snigirev, and B. N. Todorov in a technical paper in the January 1979 issue of the I.E.E.E. Transactions on Magnetics, Vol. MAG-15, No. 1, pages 420 through 423. While this technical paper gives no insight into how a practical structure can be devised and makes confusing use of the word "transistor", it may be shown that a fully practical embodiment may be constructed using the present invention as seen in Figures 10, 11, and 12.

It will be seen that the method and structure of the present invention may be extended to enable the convenient and simple production of limited-area current injection devices of the general kind suggested by Likharev et al. These limited-area current injection devices have a long, thin shape, with the length L of the barrier 23 in Figure 10 being large compared to the Josephson penetraton depth $\lambda_J$ defined by:

$$\lambda_J = (\Phi_o/2\pi \mu \, dj_o)^{1/2}$$

where $\Phi_o$ is the flux quantum constant equal to $2.07 \times 10^{-5}$ volt-seconds, $\mu$ is the permeability of the tunneling barrier medium $j_o$ is the maximum Josephson current density obtainable with a small area barrier, and d is the sum of the barrier thickness and the London penetration depths in the cooperating superconductors. The width W of barrier 23 is less than or equal to $\lambda_J$.

In Figure 10, the substrate 22 is similar in structure and in purpose to substrate 2 of Figures 1 through 9, including a superconductive ground plane and an interface layer of dielectric isolation materials. A layer 21 of superconductor material is placed upon a portion of the dielectric isolation layer of substrate 22. A barrier layer 23 is next set down on superconductor layer 21 and the superconductor layer 25' is then set down on layer 23. Layers 23, 25' have the aforementioned length L. By treating the end portions of layers 23, 25', the isolators 25", 25" are formed, as before by the oxidation, as by anodisation, of portions of the barrier 23 or of contiguous portions of both the barrier 23 and the superconductor layer 25'.

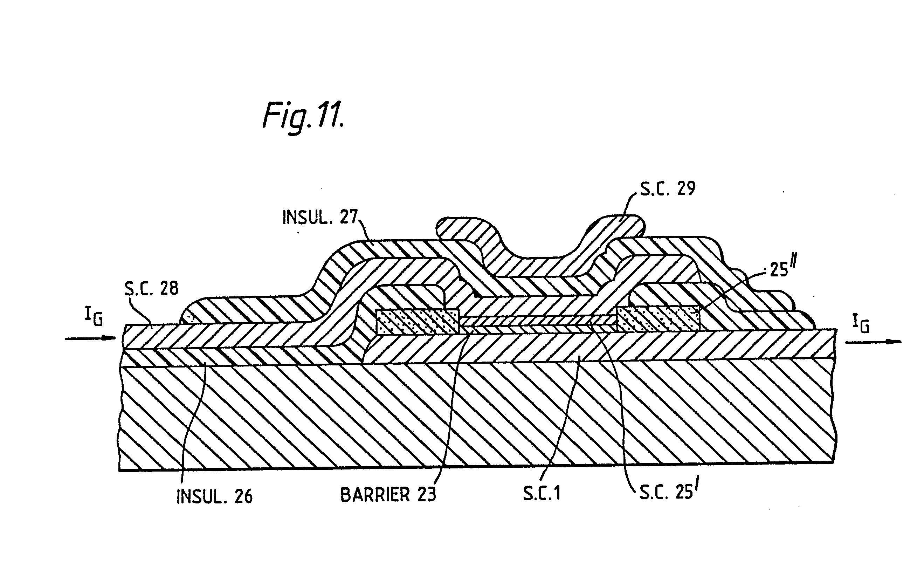

To define the area 20 of current injection, an insulating layer 26 is set down, as before, over most of the superconductor layer 23 except for the masked injection region 30. Next, a superconductor layer 28 is deposited on the current injection region 30 of layer 25', extending also over adjacent portions of insulator layer 26, forming the gate electrode. As seen in Figure 11, the gate current $I_G$ flows in superconductor gate electrode 28 in a direction perpendicular to the plane of Figure 10. A second insulator 27 is deposited over the free surface of insulator 26 and over superconductor layer 28 to provide insulation between layer 28 and a final superconductor layer 29 acting as the superconductive current control line.

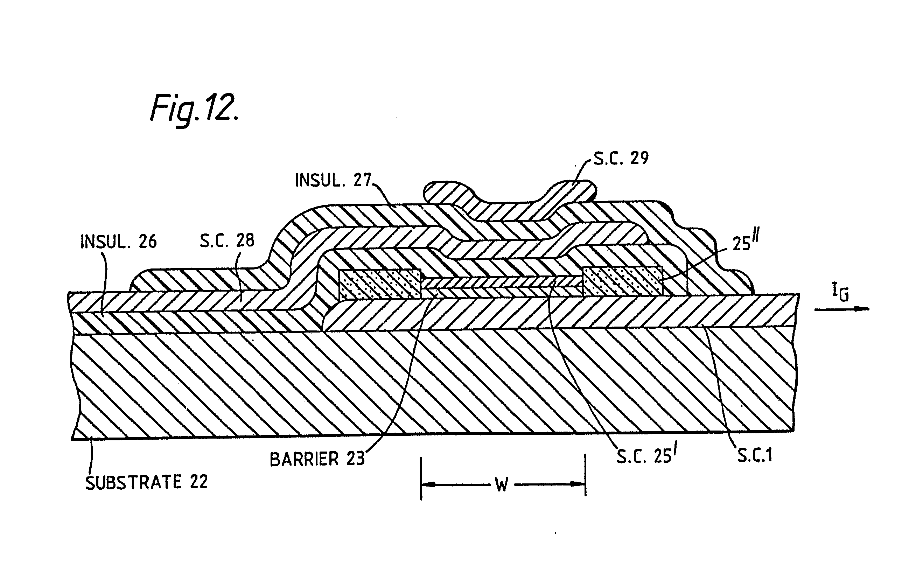

The prominent feature of the Figure 10 embodiment lies in its incorporation, according to the present invention, of a Josephson active area defined precisely by a local anodisation or oxidation process exercised only after the first and second superconducting electrodes are formed, a sequence of events important in that it permits impurities within the sealed tunnelling barrier layer interfaces to be minimised. In practice, the device of Figures 10, 11 and 12 is an inductively controlled device in which the control line 29 runs parallel to the long dimension L of the barrier 23, so that the magnetic field produced by the current in the control line is substantially perpendicular to the dimension L. In Figures 11 and 12, it is seen that the control current $I_c$ flows in superconductor 29 out of the plane of the drawings and that current $I_G$ flows parallel to the plane of the drawings. Referring again particularly to Figure 10, it is important that the gate current $I_G$ be fed and removed only from the sides of the device. While Figure 10 shows only one current injection region, an array of such injection regions may be used in place of the single illustrated region 30. Defining the active area or areas by local anodisation or other oxidation is beneficially used in the Figure 10 structure also to provide strictly equal active contiguous areas for the barrier 23 and the superconductive electrode 25'. The invention has been illustrated in the several drawings wherein dimension and proportions have been distorted as is the usual practice in an effort to make clear the actual structure of the apparatus. It will therefore be understood that the thicknesses of the various layers as shown in the drawings are not necessarily those which would be selected by the expert practioner.

**Claims**

1. A method of making a Josephson junction device including the steps of depositing on a substrate in a vacuum chamber, consecutively, a first superconductive layer (1), a tunnelling barrier layer (3), and a second superconductive layer (5), removing the device from the vacuum chamber, and depositing a mask defining the active tunnelling area, and oxidizing the material of the layers outside the mask, characterised in that the oxidation step is controlled in such a way that the second superconductive layer is fully oxidized, and the first superconductive layer is not substantially oxidized.

2. A method of making a Josephson junction device according to claim 1 in which the oxidation step is continued so as to oxidise at least a part of the tunnelling barrier layer (3).

3. A method of making a Josephson junction device according to claim 1 or claim 2 in which the oxidation is carried out by anodisation.

4. A method of making a Josephson junction device according to any preceding claim in which at least one of the said superconductive layers (1, 5) is of niobium or niobium nitride.

5. A method of making a Josephson junction device according to any preceding claim in which the tunnelling barrier layer (3) is of hydrogenated amorphous silicon, germanium, or silicon-germanium alloy.

**Revendications**

1. Procédé de fabrication d'un dispositif à jonction Josephson comprenant les étapes de dépôt sur un substrat dans une chambre à vide, consécutivement, une première couche supraconductrice (1), une couche barrière à effet tunnel (3), et une seconde couche supraconductrice (5), le retrait du dispositif de la chambre à vide et le dépôt de masque délimitant la zone active à effet tunnel, et l'oxydation du matériau des couches en dehors du masque, caractérisé en ce que l'étape d'oxydation est contrôlée de façon que la seconde couche supraconductrice soit entièrement oxydée et que la première couche supraconductrice ne soit sensiblement pas oxydée.

2. Procédé de réalisation d'un dispositif à jonction Josephson selon la revendication 1, dans lequel l'étape d'oxydation se poursuit afin d'oxyder au moins une partie de la couche barrière à effet tunnel (3).

3. Procédé de réalisation de dispositif à jonction Josephson selon la revendication 1 ou la revendication 2, dans lequel l'oxydation se fait par anodisation.

4. Procédé de réalisation d'un dispositif à jonction Josephson selon l'une quelconque des revendications précédentes, dans lequel au moins une des couches supraconductrices (1, 5) est en niobium ou nitrure de niobium.

5. Procédé de réalisation d'un dispositif à jonction Josephson selon l'une quelconque des revendications précédentes, dans lequel la couche barrière à effet tunnel (3) est en silicium, germanium hydrogéné amorphe ou un alliage silicium-germanium.

**Patentansprüche**

1. Verfahren zur Herstellung eines Gerätes mit Josephson-Übergang aus den Schritten, nacheinander auf einer Unterlage in einer Vakuumkammer eine erste supraleitende Schicht (1), eine tunnelnde Sperrschicht (3) und eine zweite supraleitende Schicht (5) niederzuschlagen, das Gerät aus der Vakuumkammer herauszunehmen, eine den aktiven, tunnelden Bereich festlegende Blende niederzubringen und das Material der Schichten außerhalb der Blende zu oxydieren, dadurch gekennzeichnet, daß der Schritt der Oxydation in einer solchen Weise gesteuert wird, daß die zweite supraleitende Schicht vollständig und die erste supraleitende Schicht nicht wesentlich oxydiert wird.

2. Verfahren zur Herstellung eines Gerätes mit Josephson-Übergang gemäß Anspruch 1, bei dem der Schritt der Oxydation fortgesetzt wird, bis zumindest ein Teil der tunnelnden Sperrschicht (3) oxydiert wird.

3. Verfahren zur Herstellung eines Gerätes mit Josephson-Übergang gemäß Anspruch 1 oder Anspruch 2, bei dem die Oxydation durch Eloxierung ausgeführt wird.

4. Verfahren zur Herstellung eines Gerätes mit Josephson-Übergang gemäß einem vorhergehenden Anspruch, bei dem zumindest eine der supraleitenden Schichten (1, 5) aus Niob oder Niobnitrid besteht.

5. Verfahren zur Herstellung eines Gerätes mit Josephson-Übergang gemäß einem vorhergehenden Anspruch, bei dem die tunnelnde Sperrschicht (3) aus hydriertem, amorphem Silicium, Germanium oder einer Silicium-Germanium-Legierung besteht.

0 046 648

## Fig.1.

S.C.1

SUBSTRATE 2

## Fig.2.

BARRIER 3
S.C.1

SUBSTRATE 2

## Fig.3.

PHOTORESIST 4
S.C.5
BARRIER 3
S.C.1

SUBSTRATE 2

## Fig.4.

S.C.5' NOT ANODIZED
S.T.5" ANODIZED
BARRIER 3
S.C.1

SUBSTRATE 2

1

## Fig. 5.

S.C.5' NOT ANODIZED

TERMINAL 6

S.T.5'' ANODIZED

ANODIZED ISOLATOR 3''

S.C.1

SUBSTRATE 2

BARRIER 3' NOT ANODIZED

## Fig. 6.

1

5

6

14

I

I

## Fig. 7.

S.C.1 NOT ANODIZED

S.C.5'' ANODIZED

BARRIER 3

S.C.1

SUBSTRATE 2

2

*Fig.8.*

S.C.5ᴵ       ─INSULATOR LAYER 7

─BARRIER 3

─S.C.1

S.C.5ᴵᴵ

─SUBSTRATE 2

*Fig.9.*

─S.C.8

S.C.5ᴵᴵ     ─INSULATOR 7

S.C.5ᴵ

─SUBSTRATE 2

*Fig.10.*

CURRENT
INJECTION
REGION 30

11    12    S.C. 28    S.C. 29

25″    25″

$I_c$    $I_c$

S.C. 21    BARRIER 23    11    12    S.C. 25′

SUBSTRATE 22

L

Fig.11.

S.C. 29

INSUL. 27

25"

S.C. 28

$I_G$

$I_G$

INSUL. 26    BARRIER 23    S.C.1    S.C. 25'

0 046 648

Fig.12.

S.C. 29

INSUL. 27

INSUL. 26    S.C. 28

$25^{ll}$

$I_G$

BARRIER 23    W    S.C. $25^{l}$    S.C.1

SUBSTRATE 22

0 046 648